(19) Europäisches Patentamt

European Patent Office

Office européen des brevets

(11) **EP 1 012 933 B1**

(12) **EUROPEAN PATENT SPECIFICATION**

(45) Date of publication and mention
of the grant of the patent:
**22.09.2004 Bulletin 2004/39**

(51) Int Cl.7: **H01S 5/06**, H01S 5/10

(21) Application number: **97900398.5**

(22) Date of filing: **27.01.1997**

(86) International application number:
**PCT/IB1997/000055**

(87) International publication number:
**WO 1998/033249 (30.07.1998 Gazette 1998/30)**

(54) **LASER DEVICE**

LASERVORRICHTUNG

DISPOSITIF LASER

(84) Designated Contracting States:
**DE FR GB**

(43) Date of publication of application:
**28.06.2000 Bulletin 2000/26**

(73) Proprietor: **International Business Machines
Corporation
Armonk, N.Y. 10504 (US)**

(72) Inventors:
- **BROVELLI, Luigi
  CH-8004 Zurich (CH)**
- **HARDER, Christoph, S.
  CH-8038 Zurich (CH)**

(74) Representative: **Klett, Peter Michael
IBM Research GmbH
Zurich Research Laboratory
Säumerstrasse 4 / Postfach
8803 Rüschlikon (CH)**

(56) References cited:
**EP-A- 0 468 482        DE-A- 3 914 001**

- **PATENT ABSTRACTS OF JAPAN vol. 005, no.
  030 (E-047), 24 February 1981 & JP 55 156381 A
  (NEC CORP), 5 December 1980,**
- **KOZLOWSKI D A ET AL: "SINGLEMODE 1.3 M
  FABRY-PEROT LASERS BY MODE
  SUPPRESSION" ELECTRONICS LETTERS, vol.
  31, no. 8, 13 April 1995, pages 648-650,
  XP000510095**
- **SCHEMMANN M F C ET AL: "KINK POWER IN
  WEAKLY INDEX GUIDED SEMICONDUCTOR
  LASERS" APPLIED PHYSICS LETTERS, vol. 66,
  no. 8, 20 February 1995, pages 920-922,
  XP000489846 cited in the application**
- **PATENT ABSTRACTS OF JAPAN vol. 010, no.
  329 (E-452), 8 November 1986 & JP 61 134094 A
  (NEC CORP), 21 June 1986,**

**Description**

TECHNICAL FIELD

The invention concerns laser devices, more particularly semiconductor laser diodes which comprise a laser cavity with an active medium which provides for a coherent standing lightwave inside the laser cavity when provided with an electrical current.

Semiconductor laser diodes have found applications in a wide variety of information-handling systems because of their compact size and because their technology is compatible with that of the associated electronic circuitry. They are being employed in areas such as data communication, optical storage and optical printing. Most commonly used are group III/V compound materials. Particularly AlGaAs and InGaAs/GaAs lasers have found extensive usage, but other materials are used nowadays too.

There is an increasing demand for semiconductor lasers which have a high output power. Such devices are well suited for use in communication lines where the number of amplifiers can be reduced if laser sources of high output power are employed. High-power laser diodes may also be used in certain medical systems or tools used to cut material, just to give some examples.

US Patent No. 5,349,596 is directed to an asymmetrical semiconductor heterostructure laser cavity and laser equipped with said cavity. The asymmetrical design is deemed to lead to a reduced operating threshold of an external pumping laser.

High-power InGaAs/GaAs quantum well lasers, for example, which emit their laser light with a wavelength near 980 nm, are widely used to pump erbium-doped fiber amplifiers. For such applications, where coupling into a single-mode fiber is necessary, the maximum usable power from a laser diode is the power level at which the output beam quality deteriorates.

Weakly index-guided ridge waveguide lasers typically are designed near the cutoff of a higher-order lateral mode. A transition from diffraction-limited fundamental-mode operation to non-diffraction-limited-mode operation often is observed in those structures at a power level significantly below the optical damage threshold, and therefore this deviation from fundamental-mode operation becomes the limiting factor in laser performance. The power-versus-current characteristics, when measured with a detector with a small numerical aperture, typically shows a kink at the transition to non-diffraction-limited operation. The maximum fundamental-mode power therefore also is called 'linear power' or 'kink power'. When increasing the output power above the kink power, the laser often returns to fundamental-mode operation. Similar effects can also be observed with other semiconductor lasers.

As outlined above, it is a major problem of today's semiconductor lasers that they show deviations from the fundamental-mode behavior which renders them unusable for many high-power applications. It is a main object of the present invention to provide improved and more reliable semiconductor diode lasers and a method for the design and fabrication of such lasers.

In the article "Kink power in weakly index guided semiconductor lasers" by Schemmann et al. in Appl. Phys. Letters 66 (8), 20 February 1995, pp 920-922 is described the dependence of the kink power on the laser length. An optimum diffraction-limited power output is expected to be obtainable by choosing the proper laser length.

In US Patent No. 5,438,585 is described a semiconductor laser diode which provides high optical power output in a single diffraction-limited farfield lobe using a conventional Fabry-Perot cavity and a planar well graded index separate confinement heterostructure (QW-GRINSCH) active region. An antiguide region is optically coupled to the active region of the laser. In one embodiment, the antiguide region has a lateral variation in the effective refractive index that forms a diverging medium that causes higher-order optical modes to have higher losses in the resonant cavity.

US Patent No. 5,394,424 discloses a semiconductor laser device with an upper clad layer on an active layer in order to ensure a stable production of fundamental transverse modes for laser operation and a rib-shaped clad layer projecting from the upper clad layer in juxtaposition with the light-emitting region of the active layer.

US Patent No. 4,761,791 describes a single-longitudinal-mode diode laser with a disconuity structure formed laterally of and possibly over the ridge along the laser active region. The discontinuity structures are arranged distributed over a significant portion of the length of the ridge or, repectively, of the length of the lateral regions, with a sufficient frequency to provide the desired effect. The individual discontinuities have a dimension in the longitudinal direction of between one-half and up to three wavelengths of the respective laser radiation wavelengths.

The Japanese Patent Application No. 55 156381 discloses a semiconductor laser with current injection regions and absorption regions. The absorption regions are arranged within the device according to a lateral intensity distribution.

The article by D. A. Kozlowski et al. "Singlemode 1.3 $\mu$m Fabry-Perot lasers by mode suppression" in ELECTRONICS LETTERS, vol. 31, no. 8 13 April 1995, pages 648 - 650, relates to the engineering of a quasi-singlemode laser with a sidemode suppression ratio of 30dB, using a minimum of three defect sites.

EP 0 468 482 A describes a buried heterostructure type distributed feedback semiconductor laser which comprises a semiconductor substrate transparent to an oscillation light beam, a laser stripe including a diffraction grating, an active layer, and a guiding layer formed on the semiconductor substrate, and semiconductor peripheral region formed so as to cover the laser stripe on the semiconductor substrate. The semiconductor peripheral region is transparent to an oscillation light beam. Rectangular grooves are formed near both side of emission facet of the laser stripe more deeply than the laser stripe. Since a radiation mode from the laser stripe is reflected and scattered by the grooves, it can hardly reach the emission facet. Therefore, the radiation mode does not interfere with an output beam from the laser.

DE 3914001 A describes a semiconductor laser with an active layer in a doped semiconductor substrate. In the active layer and/or the adjacent layers light influencing impurities are introduced.

OBJECT AND ADVANTAGES OF THE INVENTION

The invention as claimed is intended to remedy the deficiencies of known semiconductor laser diodes.

The semiconductor laser device with the features of claim 1 has the advantage that at least one higher-order lateral mode is attenuated stronger than the fundamental mode. This leads to a weaker coupling between this higher-order lateral mode and the fundamental mode and thereby to an increase of the kink power of the semiconductor laser device.

By the measures given in the dependent claims various improvements and modifications of the semiconductor laser device described in claim 1 are possible.

Positioning the loss element where the higher-order lateral mode has a relative maximum, is advantageous since there the highest amplitude of the higher-order lateral mode is located, which offers a higher potential to be attenuated.

The realization of the loss element in form of a lightwave-attenuating material that comprises a protruding part of a conductive layer, said protruding part reaching nearer to the lightwaveguide than said conductive layer, has the advantage that one can use as the conductive layer a layer that is in any case already present, e.g. a connecting layer which is used as a terminal for the laser device. This also simplifies the manufacturing process.

When the loss element comprises several loss element parts which are arranged at a predetermined distance from each other, the achievable attenuation is more selective, since inbetween the loss element parts, i.e. where the relative maxima of the fundamental mode are located, no attenuation takes place.

It proves advantageous to position the loss elements dependent on the difference in the longitudinal mode numbers of the modes existent in the lightwaveguide, because this difference automatically determines the locations where the positions of the relative maxima of the propagating modes differ most from each other. The difference in the longitudinal mode numbers of the fundamental mode and the first higher-order mode in the lightwaveguide is here abbreviated with m.

Designing the loss element such that it comprises one or more saturable light-absorbing areas which serve as traps of photoexited charge carriers, has the advantage that a known epitaxial nucleation process can be used in order to create these saturable light-absorbing areas. Furthermore, any saturable absorbing material is choosable for the saturable areas and hence allows to be chosen appropriate to different conditions, e.g. process complexity or material price.

A local confinement of the saturable light-absorbing areas (e.g. quantum dots) prevents the charge carriers to flow into adjacent regions. Therefore, the absorption saturated by the fundamental mode preserves its spatial resolution and with it the precision of attenuating the light only exactly at the position of the non-saturated light-absorbing area, particularly, where the fundamental mode intensity is low and the weaker, higher-order mode intensity maxima would appear if the saturable absorbing loss element were absent.

A detuned reflectivity of one of the reflecting planes together with a loss element that stabilizes the longitudinal mode number e.g. in a broad-area multimode laser serves in an advantageous manner for reducing the number of lateral modes.

DESCRIPTION OF THE DRAWINGS

The invention is described in detail below with reference to drawings which illustrate a specific embodiment as well as performance characteristics of devices fabricated in accordance with the teaching of the invention, and in which

FIG. 1 is a plot illustrating the measured far-field intensity distribution of a laser diode at various current levels,

FIG. 2 is a plot illustrating the output power versus current of a laser diode (solid line) and the variation of the output power versus current of a laser diode (dashed line), measured with a detector with a small numerical aperture.

FIG. 3 is a contour plot of the density of entry points of several thousand laser diodes in a kink power versus FWHM@P=30mW diagram with estimated areas of various density clusters defined by a common m-number.

FIG. 4a is a schematic view of the energy flow of a supermode with $u_{tot} = u_0 + u_1$.

FIG. 4b is a schematic view of the energy flow of a supermode with $u_{tot} = u_0 + iu_1$.

FIG. 5a is a diagram showing the spectrally-integrated electroluminescence intensity difference at the first kink of a semiconductor laser device with m=3.

FIG. 5b is a diagram showing the spectrally-integrated electroluminescence intensity difference at the first kink of a semiconductor laser device with m=4.

FIG. 5c is a diagram showing the spectrally-integrated electroluminescence intensity difference at the first kink of a semiconductor laser device with m=5.

FIG. 6a is a cross-sectional front view of a first embodiment of a laser device according to the invention.

FIG. 6b is an upper view of the device from fig. 6a.

FIG. 7 is a diagram explaining the existence of various mode number differences m for a ridge guide laser device.

FIG. 8a is a schematic depiction of the periodicity of a fundamental mode along a cavity.

FIG. 8b is a schematic depiction of the periodicity of a first-order lateral mode along a cavity.

FIG. 8c is a schematic depiction of a coherent superposition of the fundamental mode from fig. 8a and the first-order lateral mode from fig. 8c.

FIG. 9 is a perspective view of a second embodiment of a laser device according to the invention.

The figures are for sake of clarity not always shown in real dimensions, nor are the relations between the dimensions always shown in a realistic and uniform scale. The abbreviation (a.u.) means ärbitrary units"and is used in the sense that the information in the figure is not so much related to the absolute value of the contained points or curves but is contained in the relative difference of the respective point or curve related to the other depicted points or curves.

DETAILED DESCRIPTION

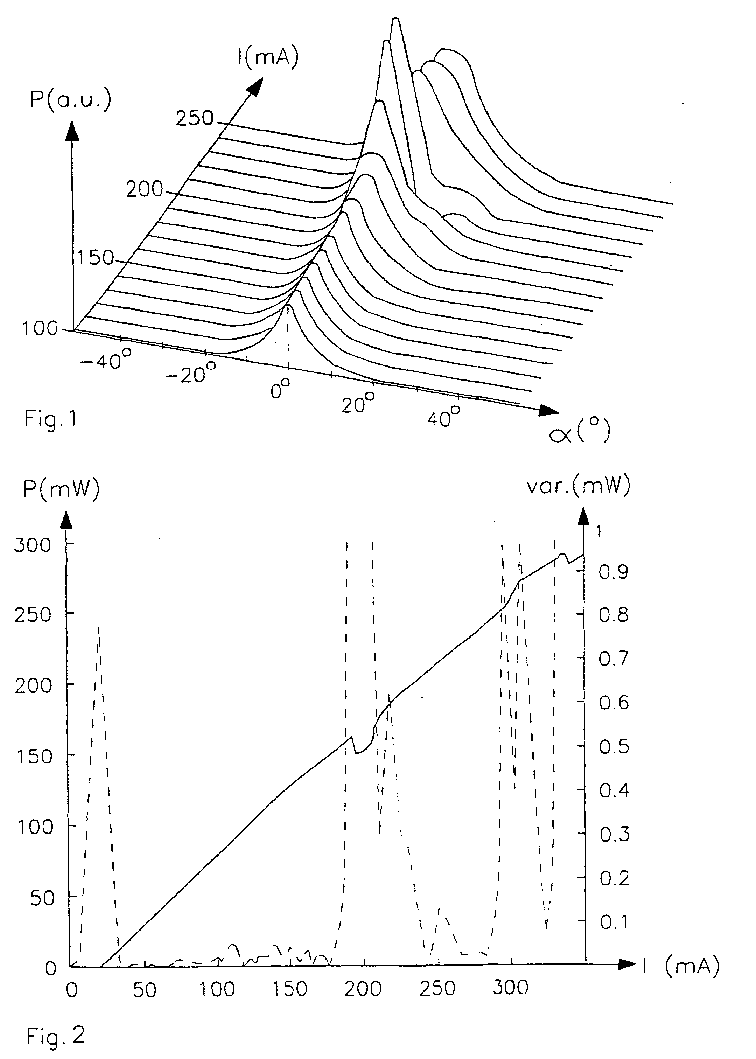

In figure 1 is depicted a plot of the measured lateral-far-field angular intensity distribution of a laser diode, particularly a strained InGaAs/GaAs single-quantum-well ridge laser device, at various levels of the operation current I between 100 and 250 mA. The intensity is given as optical output power P and shows for low values of the operation current I an output power peak at an angle $\alpha = 0°$, the output power P symmetrically decreasing with growing angle $\alpha$. The strained InGaAs/ GaAs single-quantum-well ridge laser device has here a diffraction-limited output power of more than 150 mW and shows at a certain power level a deviation from diffraction-limited fundamental-mode operation, which is associated with a lateral steering of the laser beam. The steering of the lateral far-field can here be seen at a value of the operation current I of 210-230 mA. For higher values of the operation current I, the laser device returns to fundamental-mode operation until a second kink occurs. The output power P of the laser device shows several kinks until other delimiting effects, such as heating, deteriorate the performance.

Many semiconductor laser devices show the transition from diffraction-limited fundamental-mode operation to non-diffraction-limited operation. In certain cases this deviation from fundamental-mode operation becomes the limiting factor in laser performance.

This behavior is explained by a resonant coupling between the fundamental mode and a higher-order lateral mode which is additionally guided in the laser cavity due to a deformation of the lateral index profile of the laser device caused by a local heating in the active region. A higher-order lateral mode can be guided already at moderate output power levels. The lateral steering of the far-field can be explained by the assumption of a phase-locked superposition of the fundamental mode with the higher-order lateral mode.

The corresponding output-power-versus-current characteristic is shown in a diagram in figure 2, measured with a detector with a small numerical aperture (NA). Together with the output power P, a variation var of the output power is depicted in the diagram which is defined as a smoothed second derivative of the output-power-versus-current characteristic. Since the small-NA detector is very sensitive to deviations from fundamental-mode operation, the beam steering can be observed as a 'kink' in the output-power-versus-current characteristic and in a strong increase of the variation var of the output power P.

For coupling laser light into a single-mode fiber, only the linear part of the characteristic below the first kink is useable. Thus, the 'linear power' or 'kink power' is defined as the maximum useable diffraction-limited output power P or, to be more exact, as the maximum output power for which the variation of the output power P does not exceed a predetermined value, e.g. 0.2 mW. The kinks can also be observed with integrating-spheres as detectors, though in general much weaker. This means that also the totally emitted output power P experiences the kinks, not only the power emitted in the fundamental mode.

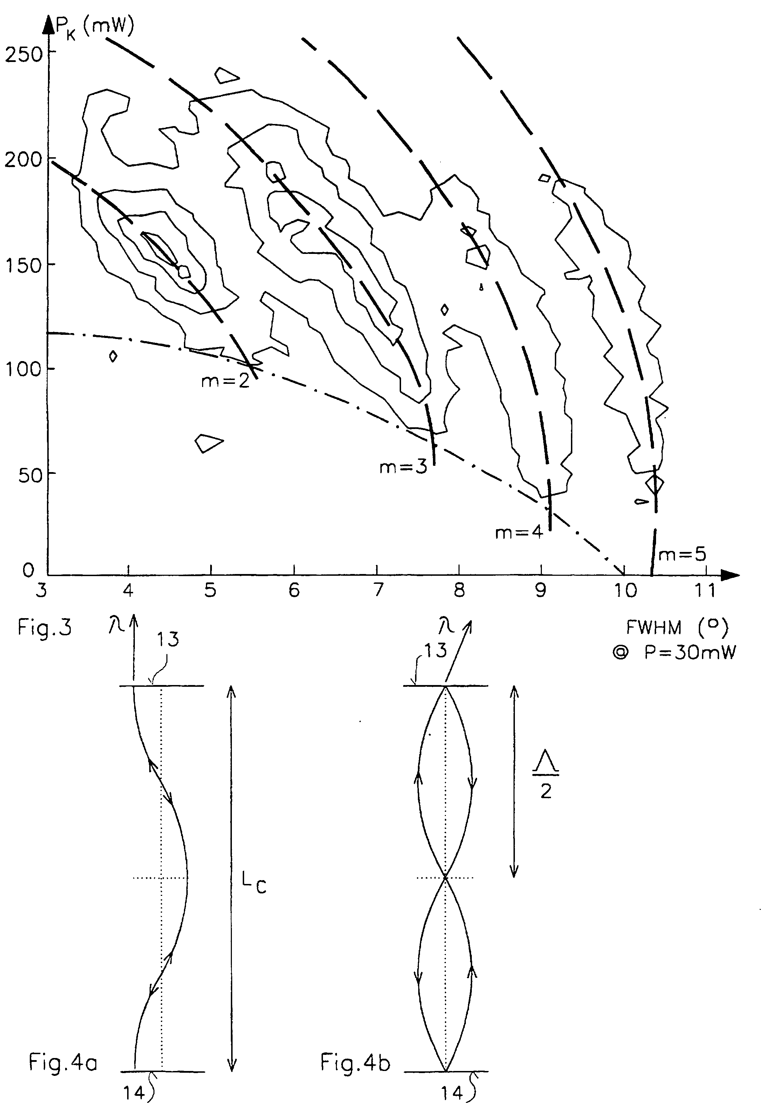

An exemplary statistic in the form of a two-dimensional histogram for a multitude of laser devices is shown in figure 3. In the diagram, countour lines are depicted, each of which represent a constant point density whereby each point represents an FWHM (Full width half maximum) value at here 30 mW output power and a kink power value for one laser device. The FWHM of the lateral far-field for a laser device measured at a predetermined value of the output power P can be used as an equivalent for the laser device's ridge height. The fact that the areas with a uniform point density are situated in fixed regions of the diagram, shows that the value of the kink power is not a random value. In contrast, a regular sawtooth-like dependence of the kink power on the height of the waveguide ridge occurs. This height is directly connected to the width of the lateral far-field, i.e., a flat laser ridge leads to stronger mode confinement and to a larger lateral far-field angle. At higher output powers, thermal effects influence the correlation of the lateral far-field to the waveguide geometry.

The regular dependence of the kink power on the ridge geometry and on the thermal deformation of the effective refractive index $n_{eff}$ allows the distinction of different clusters, i.e. areas with a high point density surrounded by areas of a lower point density. The clusters represent the experimentally found evidence for theoretically existing regions that have in common the difference m in the longitudinal mode numbers of the propagating lateral modes. These regions have a universal character, which means that they do not vary their position from one process run to the other. The dependence of the kink level on the ridge depth, thus, is a fundamental property of the waveguide geometry.

The number m of the difference in the mode numbers of the propagating modes m in the laser cavity can be assigned to each of the four clusters in figure 3. The laser device from the second cluster from the left has a kink with m = 3, the laser device from the third cluster has a kink with m = 4, and the laser device from the forth cluster has a kink with m = 5. The universal clusters are hence regions, where for every laser device which is contained within that region, a kink with a certain common m-number occurs. In reality, the clusters continue at their upper limits, which is depicted in figure 3 by dashed lines. Since only the first kink of each laser device was investigated for figure 3, the apparent upper limit of the experimentally derived clusters is artificial. Each cluster in figure 3 simply is terminated by the onset of the next cluster with the next lower m-number. This is also in agreement with the experimental observation, that a laser device shows, for increasing power, a series of kinks with increasing m-number.

A kink not only manifests itself in a lateral beam steering and an increased spontaneous emission, but also in a splitting and a shift of the laser wavelength. Usually, at the kink there is first a splitting of the laser wavelength. The branch with the shorter wavelength then 'dies out', and the laser oscillates at a longer wavelength. At power levels above the kink power, the wavelength again has its normal value. For the lateral-mode coupling, an explanation of the observed kink behavior and the clusters will be given in the following section.

A stable asymmetric far-field can be explained by a coherent, i.e. phase-locked superposition of the fundamental and a higher-order lateral mode. A necessary condition for the existence of a coherent superposition of the two modes when the laser device emits monochromatic light, is the degeneracy of the frequency $\nu$ of the two modes, i.e.

$$[1] \qquad \nu_0 = \nu_1 = \nu$$

Moreover, for being able to build a standing wave in the laser cavity, the two modes are in resonance with the laser cavity:

$$[2a] \qquad \frac{2\nu L n_e^0}{c} = l_0$$

$$[2b] \qquad \frac{2\nu L n_e^1}{c} = l_1 = l_0 - m$$

These formulas use the laser cavity length L, the longitudinal mode numbers $l_0$, $l_1$ and the effective refractive indices $n_e^0$ and $n_e^1$ of the two modes. The mode number m is a small integer, e.g. m = 1, 2, 3, 4 a. s.o.. From equations [1] to [2b], the necessary condition for the build-up of a coherent supermode is obtained:

$$[3] \qquad n_e^0 - n_e^1 = m \frac{c}{2L\nu}$$

The difference of the effective refractive indices $n_e^0$ and $n_e^1$ has to be an entire multiple of

$$\frac{c}{2L\nu} = 6.5 \cdot 10^{-4}.$$

Therefore, a hybrid supermode in principle theoretically does not exist. The waveguide has to guide two modes with the effective refractive indices $n_e^0$ and $n_e^1$ meeting the condition [3]. Although this condition is not fulfilled for the 'cold' waveguide, local heating of the lightwaveguide may shift the effective refractive indices $n_e^0$ and $n_e^1$ of the modes until condition [3] is fulfilled. At this point, the fundamental mode transfers energy resonantly to the higher-order lateral mode, and a kink occurs. Increasing the current and with it the output power P, further leads to a stronger heating of the lightwaveguide, to a further shift of the effective refractive indices $n_e^0$ and $n_e^1$, and condition [3] ceases to be met. Then there is no resonant coupling anymore, and the laser device returns to fundamental-mode operation.

Although the two modes oscillate at the same frequency $\nu$ and have the same free-space wavelength, their wavelength inside the laser cavity is different due to the different effective refractive indices $n_e^0$ and $n_e^1$. The beat length $\Lambda$ is given by:

$$[4] \qquad \Lambda = \frac{c}{\nu \left( n_r^0 - n_r^1 \right)}$$

The beat length $\Lambda$ is the length, after which the two modes have a phase difference of $2\pi$. From equations [2a] to [4] it follows directly that

$$[5] \qquad \Lambda = \frac{2L}{m}$$

For a superposition of standing wave patterns of two modes, it is thus necessary that the half beat length $\Lambda/2$ of the two modes 'fits' into the laser cavity. Considering the standing-wave intensity distribution inside the laser cavity, the relative phase between the modes can be chosen arbitrarily, i.e. the amplitude $u_{tot}$ of the supermode can be written as

$$[6] \qquad u_{tot} = u_0 + cu_1$$

with the complex amplitudes $u_0$ and $u_1$ and an arbitrary complex constant c.

Starting from one of the reflecting planes, after a quarter of the beat length $\Lambda$, the higher-order lateral mode has a phase shift of $\pi/2$ compared to the fundamental mode, and its mode peaks therefore appear between the mode peaks of the fundamental mode. Averaged over several wavelengths, the intensity distribution is homogeneous along the laser cavity, but broadened compared to the intensity distribution of the fundamental mode. This is not the case for a real c, where the positions of maximum intensity of the supermode moves from one side to the other in the waveguide. This superposition leads to an asymmetric near-field, whereas an imaginary c leads to a symmetric near-field.

In figure 4a, the energy flow of a superposition with a real c is shown, whereas in figure 4b the energy flow of a superposition with an imaginary c is depicted. Both shown modes correspond to m=2. It becomes clear that the cavity length $L_c$ is a multiple integer of the half beat length $\Lambda/2$. Also, it turns out that a real c leads to a symmetric far-field, whereas an imaginary c leads to an asymmetric far-field, thus to a beam steering. A kink, therefore, is the result of a coherent superposition of two modes with an imaginary c. From this follows that the near-field at the kink remains symmetric. The mode shown in fig. 4a corresponds to $u_{tot} = u_0 + u_1$ and leads to an asymmetric near-field and a symmetric far-field, whereas the mode shown in fig. 4b corresponds to $u_{tot} = u_0 + iu_1$ and leads to a symmetric near-field and an asymmetric far-field.

A kink is hence the result of a coherent phase-locked superposition, a supermode of two lateral modes. A condition is that the two modes are degenerate, i.e. that they oscillate at the same frequency $\nu$.

Then, resonant coupling occurs and energy is transferred resonantly from the fundamental mode to the higher-order lateral mode, leading to a laterally-shifted far-field intensity distribution. A kink can be characterized by the m-number, which is the difference of the longitudinal-mode numbers of the two modes.

There is a direction of the lateral steering. The $u_{tot} = u_0 - iu_1$ mode produces exactly the same intensity distribution inside the laser cavity as the $u_{tot} = u_0 + iu_1$ mode, but a far-field steering to the other side, this supermode traveling the other way round than the one depicted in figure 4b. This is in agreement with the experimental finding that the direction of the steering varies randomly from laser device to laser device, but is constant for one laser device.

At the kink the near-field is expected to stay symmetric. It can be observed that the near-field only shows a slight shift towards one side. compared to the large lateral steering of the far-field, shown in figure 1. This confirms the assumption of a mainly imaginary constant c. The small shift of the near-field, however, indicates that the constant c is not pure imaginary, but contains a small real part.

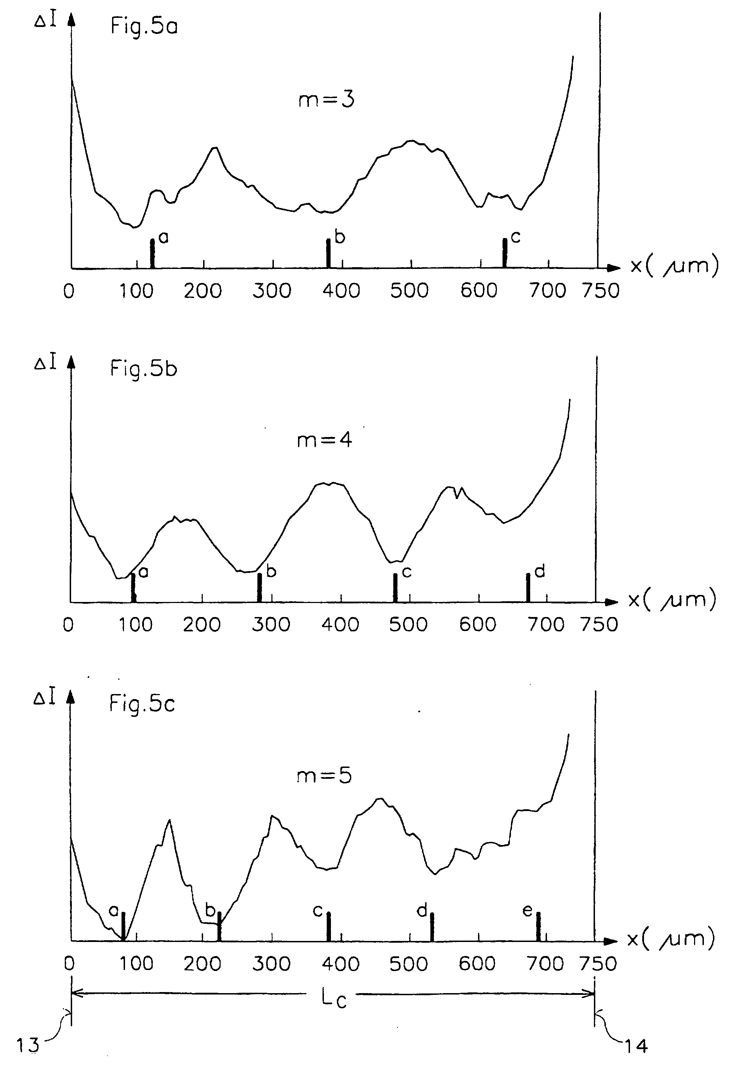

An increase of the electroluminescence intensity along the laser cavity at the kinks can be observed for all lasers. In figures 5a, b, c the difference of the electroluminescence intensity along the longitudinal axis x of the cavity at the first kink and at a current I slightly below the kink of a semiconductor laser device with m=3, 4, 5 respectively is depicted. These measurements show directly the beating between the two modes and allow for an accurate prediction of the ideal position of the loss elements.

In figure 5a a first relative intensity difference maximum can be seen at approximately 230 $\mu m$, the cavity length $L_c$ being here for all figures 750 $\mu m$. A second relative intensity difference maximum can be seen at approximately 500 $\mu m$. This corresponds to the fact that at these positions the two modes are in phase. A quarter beatlength shifted from these positions are hence located the positions where the two modes are most out of phase. There are hence the best locations a, b, c for arranging the loss elements 10.

For m=4, figure 5b depicts the alternating maxima and minima of the electroluminescence intensity difference. Here 4 minima appear which represent the four locations a, b, c, d for the here four arrangeable loss elements 10. Figure 5c confirms the rule for m=5, hence leading to five locations a, b, c, d, e. The fact that the minimum above location e is not as well visible as are the others derives from the fact that it is located nearest to the reflecting plane 14 where due to the increase of scattered light a distortion of the measured electroluminescence intensity difference occurs.

Thus, the m-number gives a concrete basis where to arrange the loss elements 10. Based on the knowledge of the intracavity intensity distribution of the propagating supermode, according to the invention, the kink behavior of the laser device can be improved in that loss elements are arranged which introduce losses to the higher-order lateral mode and hence stabilize the supermode while not affecting the fundamental mode. This approach will not move the kink, but attenuate and at best eliminate it.

In the following, examples of semiconductor laser devices with loss elements are given and described.

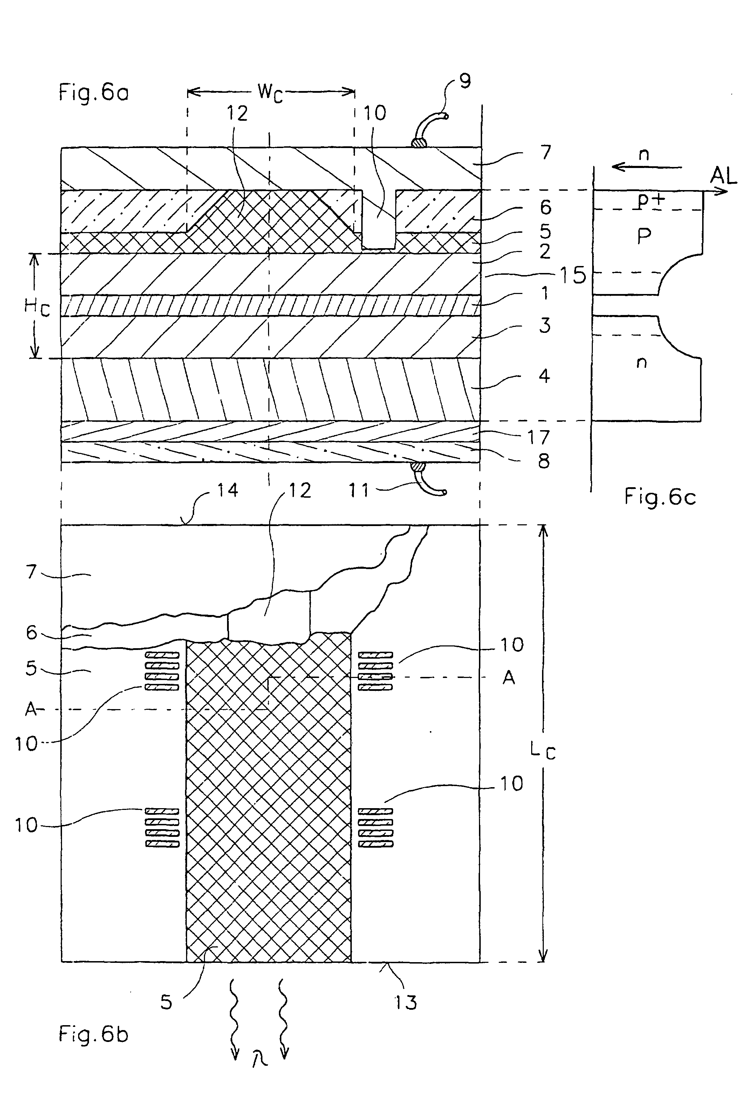

In figures 6a and 6b a first embodiment of a semiconductor laser device according to the invention is depicted. Figure 6c shows the composition profile for the semiconductive layers, respectively the refractive index n for the same. Figure 6a is a view of the laser device along a cut A-A depicted in figure 6b.

The laser device is here an injection laser diode and has the general form of a parallelepipedic bar which has a layerwise structure and comprises as central layer a quantum well zone 1. The quantum well zone 1 is on its upper side confined by an upper semiconductive confinement zone 2 whose composition varies from its upper surface towards its interface to the quantum well zone 1, such that the gap energy decreases from the upper surface towards the interface to the quantum well zone 1. The refractive index of the upper semiconductive confinement zone 2 conversely increases from its upper surface towards its interface to the quantum well zone 1. The quantum well zone 1 is on its lower side confined by a lower semiconductive confinement zone 3 whose composition varies from its lower surface towards its interface to the quantum well zone 1, such that the gap energy decreases from the lower surface towards the interface to the quantum well zone 1. The refractive index of the lower semiconductive confinement zone 3 conversely increases from its lower surface towards its interface to the quantum well zone 1. Adjacent to the lower surface of the lower semiconductive confinement zone 3 is arranged a lower cladding layer 4, which has a composition such that its refractive index is at the most equal to the refractive index of the adjacent lower semiconductive confinement zone 3 at their common interface. The quantum well zone 1 is constituted by a quantum well which has a gap energy below that of the adjacent confinement zones 2, 3 for the purpose of confining the charge carriers. The refractive index of the quantum well zone 1 can be of a random nature and can even be lower than that of the adjacent zones 2, 3. Upon the upper confinement zone 2 an upper cladding layer 5 is arranged which comprises a longitudinal ridge 12. The quantum well zone 1 is only slightly involved in the optical confinement and light guidance, the guidance being ensured by the confinement zones 2, 3 and the cladding layers 4, 5. The lower cladding layer 4 is arranged upon a semiconductive substrate 17.

The parallelepipedic bar is confined by four vertical planes two of which do not have a specific reflecting characteristic, whereas a third plane is a reflecting plane 14 and a fourth plane is a semitransparent reflecting plane 13, which serves as laser beam exit plane.

The distance between the reflecting plane 14 and the semitransparent reflecting plane 13 is the cavity length $L_c$. The ridge 12 has a base width $W_c$ and extends from the reflecting plane 14 to the semitransparent reflecting plane 13. The upper cladding layer 5 further comprises a number of cuboidic holes whose longitudinal axis is perpendicular to the longitudinal axis of the ridge 12 and which here are exemplarily grouped in groups of four. The groups are located pairwise to the left and the right of the ridge 12. Furthermore, the upper cladding layer 5 is covered up to the height of the ridge 12 with a cover layer 6, also called embedding layer, made of an isolating material. The cover layer 6 also shows the cuboidic holes. The laser device further comprises a first electrically conductive layer 7 which is arranged upon the ridge 12 and the cover layer 6 and which is connected to a first contact element 9. The part of the electrically conductive layer 7 which protrudes into a group of holes, forms there a lightwave-attenuating loss element 10 which comprises several loss element parts, each loss element part being one filled hole. Hence, along the ridge 12 here at four positions loss elements 10 are provided whose positions are chosen dependent on the difference m in the longitudinal mode numbers of the propagating modes.

On the opposite side the semiconductive substrate 17 is attached to a second electrically conductive layer 8 which is connected to a second contact element 11. The confinement zones 2, 3 together with the quantum well zone 1 form a lightwaveguide 15 with a thickness $H_c$, which serves as laser cavity with the quantum well zone 1 as active region. The laser cavity is of a Fabry-Perot type with the laser cavity length $L_c$, laser cavity height $H_c$ and the laser cavity width $W_c$. The laser device is electronically pumped. Therefore the laser shows two types of doping, namely an n- and a p-doping, which form a p-n junction and further two contact electrodes 9, 11. The two electric contacts 9, 11 serve for conducting through the active region 1 a current which provides for the generation of stimulated charge carrier recombination. The charge carriers are injected in the active zone where they recombine for producing light emission. GRINSCH (graded index separate confinement heterostructure) means that the laser device has a graded index optical guide and a separate confinement of the carriers and the light. The isolating layer 6 serves to restrict the current to the ridge 12 and to reduce the attenuating effect of the conductive layer 7 on the lightwaveguide 15.

The variation of the composition can be obtained either by modifying the temperature of an effusion cell which produces an atomic or molecular beam in the case of MBE or by successive modifications of the composition of the beam.

The active zone of the laser device is constituted by the quantum well zone 1 located in the center of a here symmetrical composition gradient structure. The quantum well zone 1 is a thin layer of a semiconductor material with an energy gap below that of the adjacent confinement zones 2, 3. The composition gradient induces a gap gradient and an optical refractive index gradient. The gap gradient improves the collection efficiency of the carriers supplied by the injection current. The refractive index gradient makes it possible to center the guided optical mode on the active zone 1. This leads to an optimum superimposing of the gain zone (quantum well) and the guided optical mode.

The loss elements 10 attenuate the higher-order lateral mode. The material of the loss elements 10 is here a metal which is known to be a very effective lightwave-attenuating material. In figure 6b, an example is depicted where the difference m of the longitudinal mode number of the fundamental mode and of the first higher-order lateral mode, which is to be attenuated, is m=2. The longitudinal mode number of the fundamental mode may hence be e.g. 2001 and the longitudinal mode number of the first higher-order lateral mode e.g. 2003. There hence exist two positions along the lightwaveguide, where the relative intensity maxima of the first higher-order lateral mode and of the fundamental mode appear most separated from each other. This is the optimal place where the first higher-order lateral mode can be attenuated while the influence of the attenuation on the fundamental mode is minimized. At either side of the ridge 12 and at each of the two positions, one of the loss elements 10 is located. Since the longitudinal mode numbers are very high compared to m, the loss elements 10 are not only consisting of one attenuating element, but comprise several loss element parts which here are realized in form of separated stripes. The transition between the total overlap of the relative maxima of the two modes and the total separation of the relative maxima of the two modes occurs in a distance which is the longer, the smaller the difference m is and generally, i.e. for real laser devices, much larger than the distance between two adjacent intensity maxima of the fundamental mode. Therefore it is possible to attenuate not only the relative maximum of the first higher-order lateral mode at one position, but also adjacent relative maxima which also are highly separated from the relative maxima of the fundamental mode. This is achieved by separating the loss element 10 into several loss element parts, arranged in a row along the lightwaveguide and located near the position where the relative intensity maxima of the two modes are most separated from each other. It would be however exacerbating, if the loss element parts were not separated from each other since the space inbetween the loss element parts would then also lead to an attenuation which is effective on the fundamental mode, this being a consequence that is normally not desired. The choice of the number of loss element parts is a question of optimizing the effect for a particular laser device. The lightwave-attenuating material which forms the loss elements 10 needs not be made of the same material as the conductive layer 7, nor need it be connected to it. A suitable method for creating the holes for the loss elements 10 is focussed ion beam etching.

An example for the materials of the various layers is GaAs for the substrate 17, $Al_{0.3}Ga_{0.7}As$ for the cladding layers 4, 5, $Al_{0.1}Ga_{0.9}As$ for the confinement zones 2, 3 and $In_{0.1}Ga_{0.9}As$ for the quantum well zone 1. The conductive layer 7 may be made of gold and the isolating layer 6 of $Si_3N_4$ or $SiO_x$.

Generally, the loss elements are situated according to the standing wave pattern of the superposition of e.g the propagating fundamental and first higher-order mode.

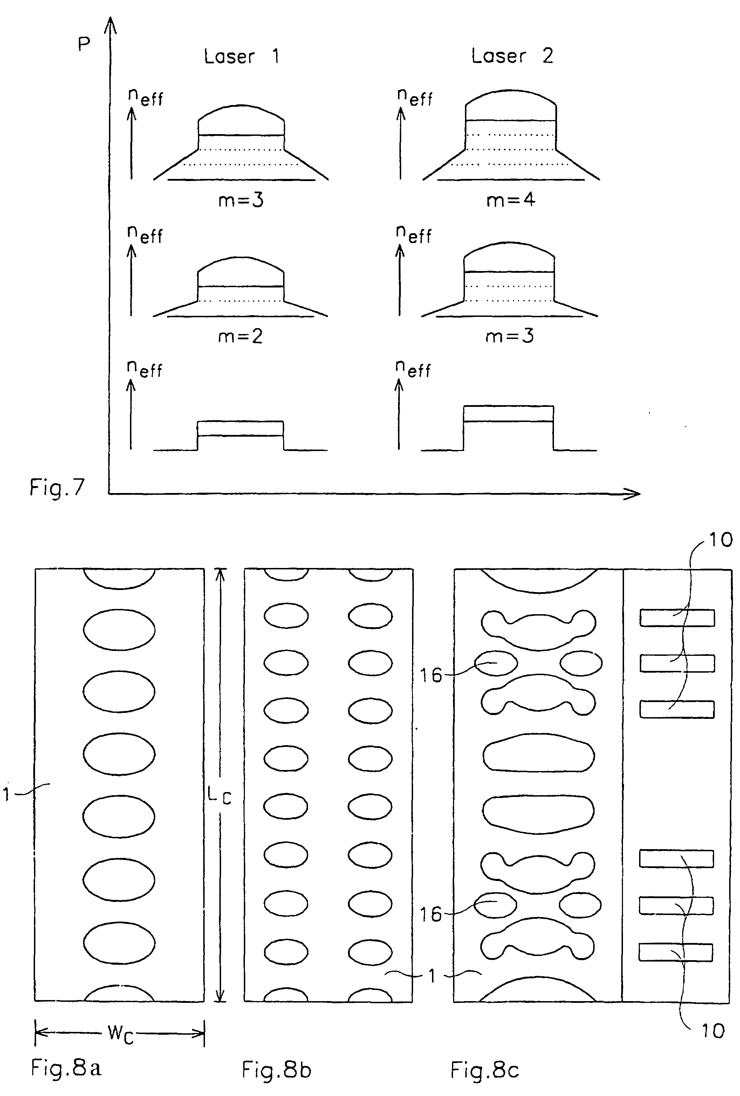

In figure 7 is shown the onset of higher-mode existence for two different ridge designs.

On the left side is shown a schematic view of the effective refractive index $n_{eff}$ of a first laser device with a flat-ridge design in three different states cross-sectional to the ridge 12. On the right side is shown a schematic view of the effective refractive index $n_{eff}$ of a second laser device with a high-ridge design in these states. The ordinate is hence representing the ridge height or the lateral far-field angle $\Theta$ and the abscissa represents the output power P.

A higher output power P automatically leads to a higher temperature in the active region. The temperature rise results in a deformation of the effective refractive index profile, namely in an artificial heightening. As can be seen, a higher ridge leaves more space between the two modes, which is equivalent to the difference m of their mode numbers. Consequently, with increasing temperature, the difference m between the fundamental mode and the first higher-order lateral mode increases. The laser device hence runs through different numbers m while raising the output power P. This is the confirmation for the existence of different kink levels with rising output power P.

By increasing the output power P, the first laser device in figure 7 reaches first a kink with m=2 and then another kink at m=3 due to thermal deformation of the index profile, which increases the difference of the effective refractive indices $n_{eff}$ of the two modes. The second laser device has the higher ridge, which implies already a minimal difference of the refractive indices $n_{eff}$ of the two modes that is too high for an m=2 superposition. Its first supermode occurs hence at m=3. The laser to the left in figure 7 therefore can be assigned to the first cluster in Fig. 3, and the laser to the right can be assigned to the second cluster.

In figures 8a to c a theoretical sketch to describe the coherent superposition of the fundamental mode with the higher-order lateral mode is depicted.

Figure 8a shows a scheme of the light intensity distribution of the fundamental mode in the active zone 1. The ellipses depict areas which surround the relative maxima of this mode. As can be seen, the fundamental mode is symmetric to the longitudinal axis of the ridge 12 and shows only one relative maximum in the orthogonal direction. In this example a total of 7 relative maxima is countable along the cavity length $L_c$.

Figure 8b shows a scheme of the light intensity distribution of the first lateral higher-order lateral mode in the active zone 1. This mode is also symmetric to the longitudinal axis of the ridge 12 but shows two relative maxima in the orthogonal direction. In this example a total of 9 relative maxima is countable along the cavity length $L_c$. The difference in the number of relative maxima along the laser cavity is the difference m of the longitudinal mode numbers and is hence here m=2. What is not depicted, is the fact that the amplitude of the relative maxima of the first lateral higher-order lateral mode is lower than the amplitude of the relative maxima of the fundamental mode.

Figure 8c shows an estimated scheme of the superposition of the two modes with an imaginary constant c. At two positions the relative maxima of the higher-order lateral mode form separated areas 16. This is the best place to put the loss elements 10 because there their attenuation effect only is effective on the higher-order lateral mode and not on the fundamental mode. However, the neighbour positions, just a half wavelength away, still represent very good places because the relative maxima of the superposed modes still have a big enough distance from each other, so that an attenuation of the first higher-order lateral mode does not extremely affect the fundamental mode. Therefore, each loss element 10 is here again realized as a group of here 3 loss element parts which are located with a predetermined distance from each other. The optimal place represents hence the rough position where to put a loss element 10, and the adjacent places represent the fine positions where also attenuating is possible. Every place where the relative maxima of the modes have different positions along the longitudinal axis of the laser cavity, is hence a place where a loss element 10, respectively loss element part can be arranged such that it attenuates the higher-order lateral mode stronger than the fundamental mode. The bigger the separation of the relative maxima of the two or more modes at the place where the loss element 10 is located, the more effective is the attenuation for the stabilization of the fundamental mode.

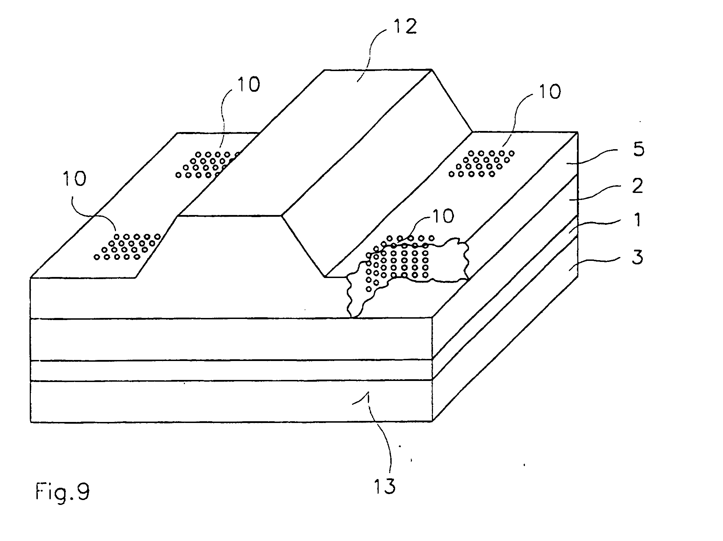

In figure 9 is shown another embodiment of a semiconductor laser device according to the invention. For sake of clarity only selected parts of the laser device are depicted, namely the confinement zones 2, 3, the quantum well zone 1, and the cladding layer 5 with the ridge 12.

The upper cladding layer 5 comprises here the loss elements 10 which comprise each an ensemble of saturable attenuating areas, each of these areas lying electronically isolated from the adjacent areas. These areas can be implied in the form of quantum dots. In this example, these quantum dots are areas in the upper cladding layer 5 which absorb light by generation of charge carriers which then are trapped in these quantum dots. The absorption remains locally defined since the quantum dots are isolated from each other by the material of the upper cladding layer 5 which is weaker- or even non-absorbing, and hence the generated charges cannot flow away. By defining the position where the quantum dots lie, the light absorption can be spacially controlled. Thus, by selecting the position where a relative intensity maximum of the higher-order lateral mode lies separated from a relative maximum of the fundamental mode as the place where the loss elements 10 are situated, this mode can be attenuated. The isolation of the saturable light-absorbing areas may be realized by embedding them in a weaker-absorbing or nonabsorbing surrounding material.

Since the quantum dots have an inherent saturability, another example is possible which does not restrict the quantum dots to the above described selected positions. In fact, the quantum dots can be positioned all along the ridge 12 thereby of course attenuating both modes, the fundamental mode and the higher-order lateral mode. Since, as already mentioned, the amplitude of the relative maxima of the higher-order lateral mode is lower than the amplitude of the relative maxima of the fundamental mode, the saturable absorption can be adjusted e.g. by determining the concentration of quantum dots, such that the attenuation does not extinguish the fundamental mode and to a large extent attenuates the higher-order lateral mode.

With other words, on a large scale, the loss elements 10 may be placed at positions where the spatial separation of the intensity maxima of the fundamental and the higher-order mode is large. On a small scale, the fundamental mode serves itself to form the loss element parts through the fact that the absorption saturation effects that the attenuation does not extinguish the fundamental mode but to a large extent attenuates the higher-order lateral mode.

In general, a loss element 10 may be realized in various forms. It need not be located at the side of the ridge 12. It also can be placed on the top of the ridge, or even buried in one of the semiconductive layers or in any other layer, also in the ridge 12. Particularly the quantum dots may be fabricated by using a common process step such as ion bombardment or lithography, or a self-organizing nucleation process during epitaxial growth, known as "Stranski-Krastanov" growth. A possible material for a saturable quantum dot is InGaAs or InAs.

The loss elements 10 can also be arranged simultaneously for several higher-order lateral modes, such that correspondingly more than one higher-order lateral mode is attenuated. the locations of the loss elements 10 are then chosen as a superposition of the locations for the single higher-order lateral modes.

The invention has been described in detail as applied to specific ridge laser diodes. It should, however, be understood that it is likewise applicable to other laser diode structures, independent of the compound semiconductors used. Also, processes and device parameters may be different from those indicated herein above. The quantum well zone 1 needs not to be limited to one quantum well it can also comprise a multiple quantum well (MQW) structure.

The proposed concept in a similar form is also applicable for multi-mode broad-area laser devices. In this case, the loss element leads to a reduction of the number of propagating lateral higher-order modes which have enough gain to oscillate. This occurs because the longitudinal mode number can be determined and stabilized for all modes by the loss elements 10. By this, the frequency or free space wavelength of a higher-order mode is decreased and the frequency increased compared to the fundamental mode. It is hence possible to shift the frequencies of the higher-order lateral modes to regions where the quantum well zone provides less optical gain. The reduction of higher-order lateral modes reduces the far-field angle and increases the laser light brightness. The output of broad-area lasers often is limited by the onset of filamentation which is a self-focussing of the laser beam and is followed by catastrophic optical mirror damage. The higher-order mode selection introduced by the loss elements 10 together with the spectral shape of the optical gain will stabilize the lateral field distribution and increase the threshold for filamentation. By optimizing the laser device it is even possible to fabricate a fundamental-mode broad-area laser. For this, the wavelength selectivity of the gain curve of the laser device can be enhanced through a detuned reflectivity of one of the reflecting planes, particularly the plane opposite to the beam exit plane. By moving the reflectivity maximum of the reflecting plane to longer wavelengths, the reflectivity at the shorter wavelengths of the higher-order modes is reduced leading to higher losses for these modes.

The size of the loss elements 10, repectively the loss element parts, in the direction of the longitudinal axis of the ridge 12, is the most critical one concerning the effect achievable with the loss elements 10. Choosing this size smaller than a quarter of the wavelength of the modes in the cavity may be a good rule to obtain a suitable effect.

In principle this dimension and the longitudinal position of the loss element, respectively loss element part should be chosen such that the influence of the loss element, respectively loss element part on the higher-order mode is maximized whereas the influence on the fundamental mode is minimized. This makes clear that the various loss elements, respectively loss element parts may even be chosen different from each other in size, shape, position and also in material and/or saturability. Even the loss element parts may again consist of individual elements, connected to or isolated from each other, following the attempt to optimize the stabilizing effect that is to be achieved.

All described embodiments of the invention can be also combined in total or in detail with each other.

**Claims**

1. Laser device, comprising a longitudinal lightwaveguide (15) being terminated at its opposite ends by at least partially reflecting planes (13, 14), said lightwaveguide (15) comprising an active region (1), being stimulatable for charge carrier recombination which leads to the generation of a fundamental mode and of at least one higher-order lateral mode of a coherent lightwave inside said lightwaveguide (15), **characterized in that** loss elements (10) are arranged at said lightwaveguide (15) and at least approximately near a position where a relative intensity maximum of said higher-order lateral mode and a relative intensity maximum of said fundamental mode are located at different positions along the longitudinal axis of the lightwaveguide (15), said loss elements (10) attenuating said higher-order lateral mode.

2. Laser device according to claim 1, **characterized in that** the loss elements (10) are situated where a relative intensity maximum of a higher-order lateral mode of said lightwave would be situated if said loss elements (10) were absent.

3. Laser device according to claim 1 or 2, **characterized in that** the loss elements (10) comprise a lightwave-attenuating material which comprises a protruding part of a conductive layer (7), said protruding part reaching nearer to the lightwaveguide (15) than said conductive layer (7).

4. Laser device according to one of claims 1 to 3, **characterized in that** the loss elements (10) comprise several loss element parts which are arranged at a predetermined distance from each other.

5. Laser device according to one of claims 1 to 4, **characterized in that** the position of the loss elements (10) is chosen dependent on the difference (m) of the longitudinal mode numbers of the fundamental mode and of the higher-order lateral mode existent in the lightwaveguide (15).

6. Laser device according to one of claims 1 to 5, **characterized in that** the loss elements (10) comprise one or more saturable light-absorbing areas embedded in a weaker-absorbing or non-absorbing surrounding material.

7. Laser device according to claim 6, **characterized in that** the saturable light-absorbing areas are separated from each other for locally confining the absorbing effect.

8. Laser device according to one of claims 1 to 7, **characterized in that** at least one of the at least partially reflecting planes (13, 14) has a detuned reflectivity.

**Patentansprüche**

1. Laservorrichtung, welche einen an beiden gegenüberliegenden Enden durch zumindest teilreflektierende Flächen (13, 14) abgeschlossenen longitudinalen Lichtwellenleiter (15) umfasst, wobei der Lichtwellenleiter (15) einen aktiven Bereich (1) umfasst, der zur Ladungsträgerrekombination angeregt werden kann, welche zur Erzeugung eines Grundmode und mindestens eines Nebenmode höherer Ordnung einer kohärenten Lichtwelle im Innern des Lichtwellenleiters (15) führt, **dadurch gekennzeichnet, dass** am Lichtwellenleiter (15) Dämpfungsglieder (10) mindestens näherungsweise an einer Stelle angebracht sind, wo sich an verschiedenen Stellen entlang der Längsachse des Lichtwellenleiters (15) ein relatives Intensitätsmaximum des Nebenmode höherer Ordnung und ein relatives Intensitätsmaximum des Grundmode befinden, wobei die Dämpfungsglieder (10) die Nebenmoden höherer Ordnung dämpfen.

2. Laservorrichtung nach Anspruch 1, **dadurch gekennzeichnet, dass** sich die Dämpfungsglieder (10) dort befinden, wo sich ein relatives Intensitätsmaximum eines Nebenmode höherer Ordnung der Lichtwelle befände, wenn die Dämpfungsglieder (10) nicht vorhanden wären.

3. Laservorrichtung nach Anspruch 1 oder 2, **dadurch gekennzeichnet, dass** die Dämpfungsglieder (10) ein Lichtwellen dämpfendes Material umfassen, welches einen hervorstehenden Teil einer leitfähigen Schicht (7) umfasst, wobei der hervorstehende Teil näher zum Lichtwellenleiter (15) reicht als die leitfähigen Schicht (7).

4. Laservorrichtung nach einem der Ansprüche 1 bis 3, **dadurch gekennzeichnet, dass** die Dämpfungsglieder (10) mehrere Dämpfungsgliedteile umfassen, welche in einem bestimmen Abstand voneinander angeordnet sind.

5. Laservorrichtung nach einem der Ansprüche 1 bis 4, **dadurch gekennzeichnet, dass** die Position der Dämpfungsglieder (10) entsprechend der Differenz (m) der Längsmodenzahlen des Grundmode und des Nebenmode höherer Ordnung im Lichtwellenleiter (15) gewählt ist.

6. Laservorrichtung nach einem der Ansprüche 1 bis 5, **dadurch gekennzeichnet, dass** die Dämpfungsglieder (10) einen oder mehrere sättigungsfähige, licht-absorbierende Bereiche umfassen, die in schwächer absorbierendes oder nicht absorbierendes Umgebungsmaterial eingebettet sind.

7. Laservorrichtung nach Anspruch 6, **dadurch gekennzeichnet, dass** die sättigungsfähigen, licht-absorbierenden Bereiche voneinander getrennt sind, um den Absorptionseffekt lokal zu begrenzen.

8. Laservorrichtung nach einem der Ansprüche 1 bis 7, **dadurch gekennzeichnet, dass** mindestens eine der zumindest teilreflektierenden Flächen (13, 14) einen nicht abgestimmten Reflexionsgrad aufweist.

**Revendications**

1. Dispositif à laser, comprenant un guide d'onde de lumière longitudinal (15) qui se termine à ses extrémités opposées par des plans au moins partiellement réfléchissants (13, 14), ledit guide d'onde de lumière (15) comprenant une région active (1), qui peut être stimulée pour une recombinaison des porteurs de charges qui conduit à la génération d'un mode fondamental et d'au moins un mode latéral d'ordre supérieur d'une onde lumineuse cohérente à l'intérieur dudit guide d'onde de lumière (15), **caractérisé en ce que** des éléments à perte (10) sont disposés au niveau dudit guide d'onde de lumière (15) et au moins approximativement près d'une position où une intensité relative maximum dudit mode latéral d'ordre supérieur et une intensité maximum relative dudit mode fondamental sont situées à des positions différentes le long de l'axe longitudinal du guide d'onde de lumière (15), lesdits éléments à perte (10) atténuant ledit mode latéral d'ordre supérieur.

2. Dispositif à laser selon la revendication 1, **caractérisé en ce que** les éléments à perte (10) sont situés à l'endroit où un maximum d'intensité relative du mode latéral d'ordre supérieur de ladite onde lumineuse serait situé si lesdits éléments à perte (10) étaient absents.

3. Dispositif à laser selon la revendication 1 ou 2, **caractérisé en ce que** les éléments à perte (10) comprennent un matériau d'atténuation d'onde lumineuse qui comprend une partie protubérante d'une couche conductrice (7), ladite partie protubérante se rapprochant davantage du guide d'onde de lumière (15) que ladite couche conductrice (7).

4. Dispositif à laser selon l'une des revendications 1 à 3, **caractérisé en ce que** les éléments à perte (10) comprennent plusieurs parties d'éléments à perte qui sont disposés à une distance prédéterminée les unes des autres.

5. Dispositif à laser selon l'une des revendications 1 à 4, **caractérisé en ce que** la position des éléments à perte (10) est choisie suivant la différence (m) des nombres de mode longitudinaux du mode fondamental et du mode latéral d'ordre supérieur existant dans le guide d'onde de lumière (15).

6. Dispositif à laser selon l'une des revendications 1 à 5, **caractérisé en ce que** les éléments à perte (10) comprennent une ou plusieurs zones d'absorption de lumière pouvant être saturées noyées dans un matériau environnant à plus faible absorption ou sans absorption.

7. Dispositif à laser selon la revendication 6, **caractérisé en ce que** les zones d'absorption de lumière pouvant être saturées sont séparées les unes des autres afin de limiter localement l'effet d'absorption.

8. Dispositif à laser selon l'une des revendications 1 à 7, **caractérisé en ce qu'**au moins l'un des plans au moins partiellement réfléchissants (13, 14) présente une réflectivité désaccordée.

Fig.1

Fig. 2

Fig.3

Fig.4a

Fig.4b

Fig.5a  m=3

Fig.5b  m=4

Fig.5c  m=5

Fig.6a

Fig.6c

Fig.6b

Fig.7

Fig.8a        Fig.8b        Fig.8c

Fig.9